# EUROPEAN PATENT APPLICATION

(11) **EP 2 531 006 A1**
(43) Date of publication of application: **05.12.2012**
(21) Application number: 11736830.8
(22) Date of filing: 06.01.2011
(51) Int. Cl.: H05B 33/12, H01L 51/50, H05B 33/22

(54) **LIGHT-EMITTING DEVICE**

(30) Priority: 29.01.2010 JP 2010018091
(71) Applicant: Sumitomo Chemical Co., Ltd, Chuo-ku, Tokyo 104-8260 (JP)
(72) Inventor: GODA, Tadashi, Tsukuba-shi Ibaraki 305-0821 (JP)
(74) Representative: Jackson, Martin Peter
(86) International application number: PCT/JP2011/050110
(87) International publication number: WO 2011/093115

(57) **Abstract**

To provide a light-emitting device (1) comprising a plurality of organic EL elements (11) having a composition by which an organic EL element in which the film thickness of a common layer is varied according to the type of the organic EL element can be formed with a small number of steps. The light-emitting device comprises a supporting substrate, a plurality of partitions (3) extending in a line direction different from a column direction at a prescribed interval in a prescribed column direction, and a plurality of organic EL elements provided in each space between the partitions adjacent to each other in the column direction at a prescribed interval in the line direction. The organic EL elements are classified into m types of organic EL elements and each of them has a common layer provided commonly to all types of organic EL elements and a pair of electrodes configured to put the common layer therebetween. The area between the partitions adjacent to each other in the column direction as viewed from one side of the thickness direction of the supporting substrate is set according to a type of the organic EL element provided between the partitions and the film thickness of the common layer of the organic EL elements is set according to the area between the partitions viewed from one side of the thickness direction.

## Description

### TECHNICAL FIELD

The present invention relates to a light-emitting device.

### BACKGROUND ART

The display device comprises various types such as a liquid crystal display device and a plasma display device. One of them is a display device using an organic electroluminescent (hereinafter, EL) element as a light source of a pixel.

In a display device, organic EL elements placed so as to align on a substrate. On the substrate, a plurality of partitions for dividing the organic EL elements are arranged in a stripe pattern. In other words, on the substrate, a plurality of concave portions defined by a plurality of partitions are provided in a stripe pattern. A plurality of organic EL elements are provided in a plurality of respective concave portions and are arranged in the concave portions along an extending direction of the concave portion (hereinafter, the "extending direction of the concave portion" may be called as a "line direction" and a direction perpendicular to the line direction may be called, for example, as a "column direction") at a prescribed interval.

In a color display device using an organic EL element, usually, for expressing a desired color, three types of organic EL elements emitting light of any one type of red, green, and blue are provided. For example, a color display device is achieved by arranging three lines of (I) to (III) below in which a plurality of organic EL elements emitting red light, green light, and blue light are arranged in each concave portion in the column direction repeatedly in this order:
(I) a line in which a plurality of organic EL elements emitting red light are arranged with a prescribed interval;
(II) a line in which a plurality of organic EL elements emitting green light are arranged with a prescribed interval; and
(III) a line in which a plurality of organic EL elements emitting blue light are arranged with a prescribed interval.

The organic EL element is constituted by comprising a pair of electrodes and a light-emitting layer placed between the electrodes. The three types of organic EL elements can be manufactured by forming a light-emitting layer emitting any one type of light of red, green, and blue according to the type of the organic EL element. In this case, it is necessary to form a light-emitting layer emitting light of a prescribed color in a prescribed line (concave portion) according to the type of the organic EL element. For example, when forming a light-emitting layer emitting red light, by supplying ink containing a material of a light-emitting layer emitting red light to a line (concave portion) in which the light-emitting layer is to be formed and further by solidifying the ink, a light-emitting layer emitting red light can be formed. A light-emitting layer emit blue or green light can also be formed in the same manner using a material of a light-emitting layer emit light of a corresponding color. As described above, when three types of light-emitting layers are formed in prescribed lines (concave portions) respectively, it is necessary to paint a line (concave portion) in which any one of the types of light-emitting layers is formed in the corresponding color with the corresponding ink.

The organic EL element may have not only a light-emitting layer, but also, if necessary, a hole injection layer, a hole transport layer, and the like. A layer not so much affecting the emission color in comparison with the light-emitting layer such as the hole injection layer and the hole transport layer can be provided as a layer common to all of the three types of organic EL elements (hereinafter, also called as "common layer") irrespective of the emission color of the organic EL element, that is, irrespective of the type of the organic EL element. Therefore, if all of the common layers for all types of organic EL elements are formed in the same film thickness, all of the common layers for the three types of organic EL elements can be formed in the same step. That is, it is not necessary to vary the applying amount of an ink containing a material of the common layer according to a prescribed line (concave portion).

However, for example, in order to control the distance between a pair of electrodes for the purpose of generating optical resonance, the film thickness of the common layer may be varied for each type of the organic EL elements. For controlling the film thickness of the common layer according to the type of organic EL element, even if a material for the common layer is common to all of the three types of organic EL elements, the applying amount of the ink is necessary to be set according to the type of the organic EL element. That is, for forming a common layer having a large film thickness, the applying amount of the ink is necessary to be increased compared with the applying amount of the ink when a common layer having a smaller film thickness is formed. Therefore, in the conventional art, even with respect to the common layer, the applying amount of the ink has been varied according to the type of the organic EL element like the light-emitting layer (for example, see Patent Document 1).

### RELATED ART DOCUMENTS

### Patent Document

Patent Document 1: JP 2009-164236 A

### DISCLOSURE OF INVENTION

### PROBLEM TO BE SOLVED BY THE INVENTION

As described above, in the conventional art, the common layer has been formed in a different step according to a type of organic EL element, which arises a problem that the number of steps increases.

Accordingly, it is an object of the present invention to provide a light-emitting device comprising a plurality of organic EL elements having a composition by which organic EL elements having different film thicknesses of the common layer according to the type of the organic EL element can be formed with a small number of steps.

### MEANS FOR SOLVING PROBLEM

The present invention provides [1] to [9] described below.
[1] A light-emitting device comprising:
   a supporting substrate;
   a plurality of partitions provided on the supporting substrate and extending at a prescribed interval in a prescribed column direction in a line direction different from the column direction on the supporting substrate; and
   a plurality of organic electroluminescent elements provided in each space between the partitions adjacent to each other in the column direction at a prescribed interval in the line direction,
   wherein the organic electroluminescent elements are classified into two or more types of organic electroluminescent elements emitting lights of colors different from each other, each of the organic electroluminescent elements having a common layer provided commonly to all types of the organic electroluminescent elements and a pair of electrodes configured to put the common layer therebetween,
   each area between the partitions adjacent to each other in the column direction as viewed from one side of a thickness direction of the supporting substrate is set according to a type of the organic electroluminescent element provided between the partitions, and
   a film thickness of the common layer of the organic electroluminescent elements is set according to the area between the partitions viewed from one side of the thickness direction.
[2] The light-emitting device according to above [1], wherein the two or more types of organic electroluminescent elements are provided so that:
   in the line direction, the organic electroluminescent elements of an identical type are provided at a prescribed interval; and
   in the column direction, the two or more types of organic electroluminescent elements are repeatedly provided so that a prescribed arrangement in which all types of the organic electroluminescent elements are arranged in order is continued repeatedly in the column direction.
[3] The light-emitting device according to above [1] or [2], wherein a side face of each partition opposite to another partition adjacent to the partition in the column direction extends flat in the line direction, and the interval between the partitions adjacent to each other in the column direction is set according to a type of the organic electroluminescent element provided between the partitions.
[4] The light-emitting device according to any one of above [1] to [3], wherein the organic electroluminescent elements are arranged at a prescribed interval so that in the column direction, the intervals between centers of the organic electroluminescent elements are identical.
[5] The light-emitting device according to above [1] or [2], wherein each interval between the partitions adjacent to each other in the column direction is set such that a width of the interval is varied along the line direction according to the type of the organic electroluminescent element provided between the partitions.
[6] The light-emitting device according to any one of above [1] to [5], wherein the area between the partitions adjacent to each other in the column direction as viewed from one side of the thickness direction of the supporting substrate is set such that the film thickness of the common layer of the organic electroluminescent element provided between the partitions becomes a film thickness by which optical resonance occurs in the organic electroluminescent element.
[7] The light-emitting device according to any one of above [1] to [6], wherein the shorter a light-emitting wavelength of the organic electroluminescent element provided between the partitions is, the larger the area between the partitions adjacent to each other in the column direction as viewed from one side of the thickness direction of the supporting substrate is set.
[8] The light-emitting device according to any one of above [1] to [7], wherein the organic electroluminescent elements are set such that a width in the line direction of an organic electroluminescent element having shortest element life among the two or more types of organic electroluminescent elements becomes largest.
[9] The light-emitting device according to any one of above [1] to [8], wherein each of the organic electroluminescent elements comprise a plurality of common layers, and a film thickness of all the common layers of each of the organic electroluminescent elements is set according to the area between the partitions viewed from one side of the thickness direction.

### EFFECT OF THE INVENTION

According to the present invention, the common layers having different film thicknesses according to the types of the organic EL elements can be formed in the same step, so that there can be achieved a light-emitting device comprising a plurality of organic EL elements having a composition capable of being formed with a small number of steps.

### BRIEF DESCRIPTION OF DRAWINGS

FIG. 1 is a plan view schematically illustrating a light-emitting device of an embodiment according to the present invention.
FIG. 2 is a cross-sectional view schematically illustrating the light-emitting device.
FIG. 3 is a view schematically illustrating a light-emitting device in which an organic EL element having the shortest element life among m types of organic EL elements is an organic EL element having the largest width in the line direction.
FIG. 4 is a plan view schematically illustrating a light-emitting device in which the width of the interval between the partitions is varied along the line direction according to the type of the organic EL element provided between the partitions.
FIG. 5 is a plan view schematically illustrating a light-emitting device in which the intervals P1, P2, and P3 between the centers of a plurality of organic EL elements in the column direction Y are set to a value that is periodically changed.

### DESCRIPTION OF EMBODIMENTS

Hereinafter, referring to the drawings, one embodiment of the present invention is described. Here, in the description below, in each drawing, the shape, the size, and the arrangement of the constitutional element are illustrated only schematically to a degree by which the present invention can be comprehended, and the present invention should not be construed as being particularly limited by the drawings. In each drawing, the same component is illustrated with the same symbol and the duplicate explanation for the same component may be omitted.

A light-emitting device of the present invention is a light-emitting device comprising: a supporting substrate; a plurality of partitions provided on the supporting substrate with a prescribed interval in a prescribed column direction, and extending in a line direction different from the column direction; and a plurality of organic EL elements provided in each space between the partitions adjacent to each other in the column direction with a prescribed interval in the line direction. The organic EL elements are classified into m types (the symbol "m" represents a natural number of 2 or more) of organic EL elements emitting lights of different colors, and each of them has a common layer provided commonly to all types of the organic EL elements and a pair of electrodes configured to put the common layer therebetween. The each area between the partitions adjacent to each other in the column direction as viewed from one side of the thickness direction of the supporting substrate (hereinafter, also expressed as "in a plan view") is set according to a type of the organic EL element provided between the partitions and the film thickness of the common layer of the organic EL elements is set according to the area of a space between the partitions viewed from one side of the thickness direction.

The light-emitting device is utilized, for example, as a display device. The display device is mainly classified into an active matrix driven-type device and a passive matrix driven-type device. Although the present invention is applicable to both driven-type devices, in the present embodiment, as one example, the active matrix driven-type display device is described.

### <Composition of light-emitting device>

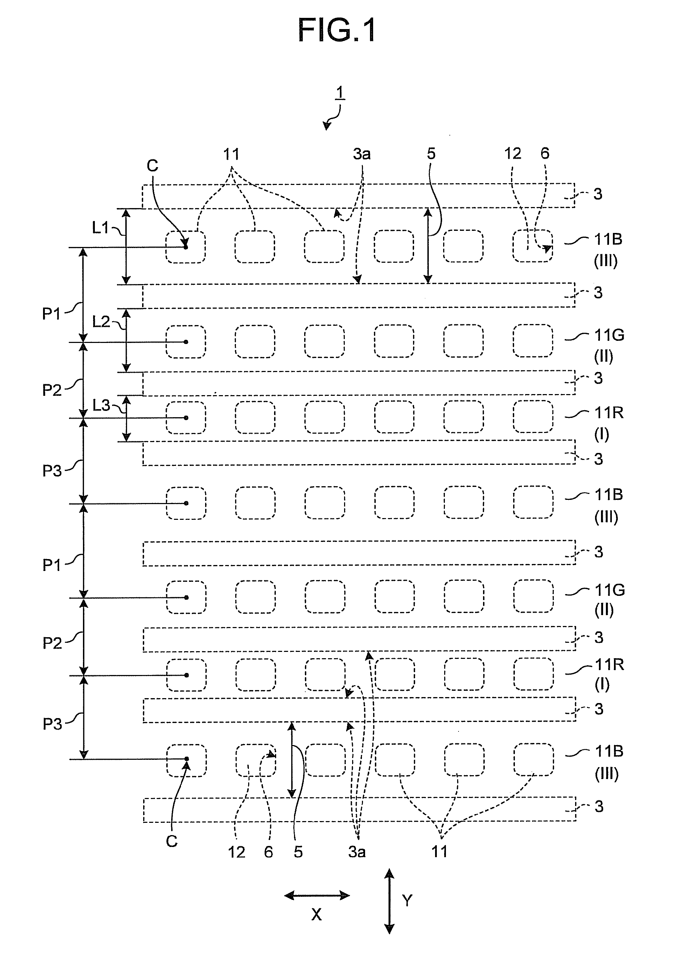

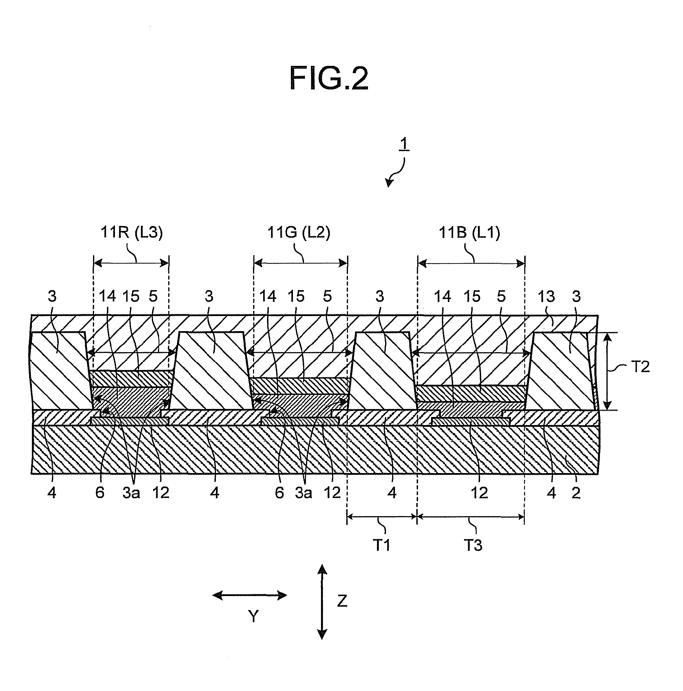

First, the composition of the light-emitting device is described. FIG. 1 is a plan view schematically illustrating the light-emitting device of the present embodiment, and FIG. 2 is a cross-sectional view schematically illustrating the light-emitting device.
As illustrated in FIG. 1 and FIG. 2, a light-emitting device 1 is constituted by mainly comprising: a supporting substrate 2; a plurality of organic EL elements 11 (11R, 11G, and 11B) formed on the supporting substrate 2; a partition 3 provided for dividing the organic EL elements 11; and an insulating film 4 for electrically insulating each organic EL element 11.

In the present embodiment, the organic EL elements 11 are individually arranged in a matrix shape on the supporting substrate 2. That is, the organic EL elements 11 are individually arranged at a prescribed interval in the line direction X and at a prescribed interval in the column direction Y. In the present embodiment, the line direction X and the column direction Y cross orthogonally each other and each of the line direction X and the column direction Y crosses orthogonally the thickness direction Z of the supporting substrate 2.

In the present embodiment, a plurality of linear-shaped partitions 3 extending substantially parallel to each other in the line direction X are provided on the supporting substrate 2. The partition 3 is provided in a so-called stripe pattern in a plan view. Each partition 3 is provided between the organic EL elements 11 adjacent to each other in the column direction Y. In other words, a plurality of organic EL elements 11 are provided between the partitions 3 adjacent to each other in the column direction Y. A plurality of organic EL elements 11 are arranged in each space between the partitions 3 adjacent to each other at a prescribed interval in the line direction X. Hereinafter, a depression defined by a pair of partitions 3 adjacent to each other in the column direction Y and the supporting substrate 2 may be called as a "concave portion 5". A plurality of concave portions 5 correspond to individual prescribed lines.

In the present embodiment, three types of organic EL elements 11 are provided on the supporting substrate 2. That is, the symbol "m" representing a natural number of 2 or more represents a value "3" in the present embodiment. A plurality of m types (in the present embodiment, "m=3") of organic EL elements 11 are repeatedly provided in a prescribed alignment sequence so that in the line direction X, the organic EL elements 11 of the same type are provided at a prescribed interval and in the column direction Y, m types of organic EL elements 11 are repeatedly arranged so that the types of two organic EL elements 11 adjacent to each other in the column direction Y do not become the same as each other and a prescribed arrangement of all types of the organic EL elements 11 is continued in the column direction.

The light-emitting device 1 for a color display device can be achieved by repeatedly (in FIG. 1, repeatedly from below to upper) arranging, for example, (I) a line in which a plurality of organic EL elements 11R emitting red light are arranged at a prescribed interval in the line direction X, (II) a line in which a plurality of organic EL elements 11G emitting green light are arranged at a prescribed interval in the line direction X, and (III) a line in which a plurality of organic EL elements 11B emitting blue light are arranged at a prescribed interval in the line direction X, in this order in the column direction Y.

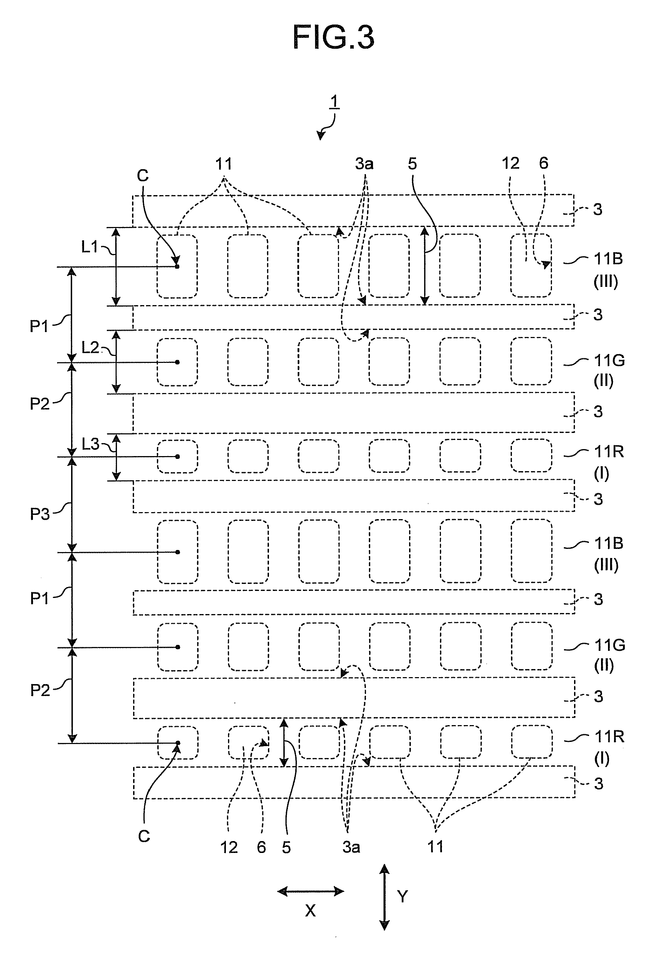

As illustrated in FIG. 3, the partition 3 has a bar shape of which cross-sectional shape in a direction perpendicular to the extending direction thereof is a trapezoid shape. The each area between the partitions 3 adjacent to each other in the column direction as viewed from one side of the thickness direction of the supporting substrate 2 is set according to a type of the organic EL element 11 provided between the partitions 3. For example, in the lines corresponding to (I), (II), and (III), the areas between the partitions 3 adjacent to each other in the column direction in a plan view are different from each other. Although the width of each line of (I), (II), and (III) in the column direction Y is defined by intervals L1, L2, and L3 between the partitions 3 adjacent to each other, in the present embodiment, by varying the intervals L1, L2, and L3 between the partitions 3 adjacent to each other, the areas between the partitions 3 adjacent to each other in a plan view are varied.

That is, in the present embodiment, the side faces 3a of the partitions 3 adjacent to each other in the column direction that are opposite to each other extend flat in the line direction X, and by setting the interval between the partitions 3 adjacent to each other in the column direction Y according to a type of the organic EL element 11 provided between the partitions 3 adjacent to each other, the area between the partitions 3 adjacent to each other in the column direction Y in a plan view is varied according to a type of the organic EL element 11.

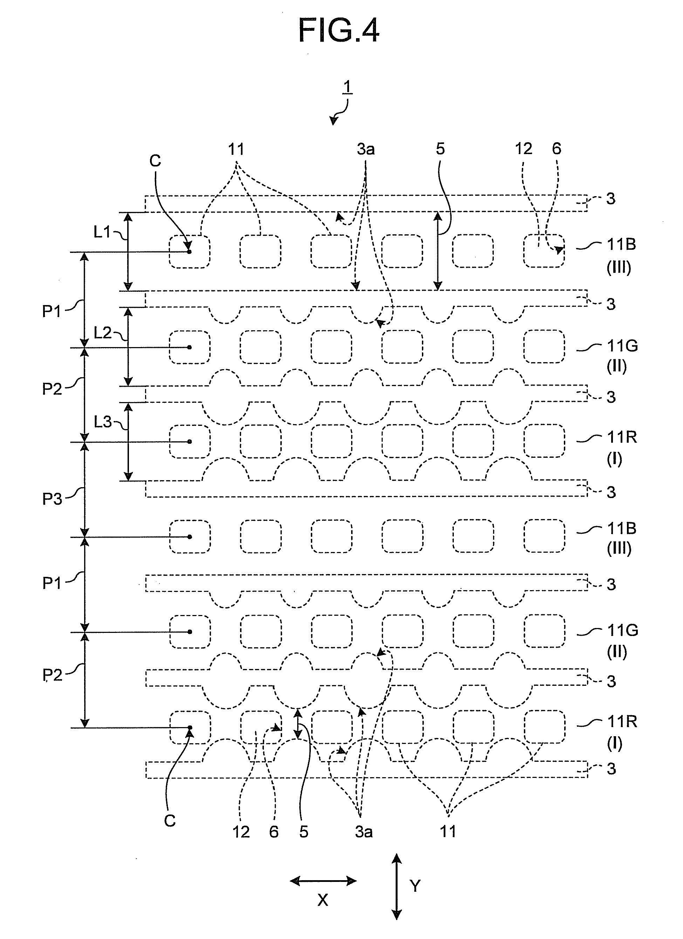

"The side faces 3a of the partitions 3 adjacent to each other in the column direction Y that are opposite to each other extend flat in the line direction" means that "a partition 3 having a prescribed width extends in a substantially linear shape in the line direction X while maintaining the width" and that "the width of the partition 3 is hardly changed along the line direction X unlike a partition 3 illustrated in FIG. 4 of which width is changed along the line direction X".

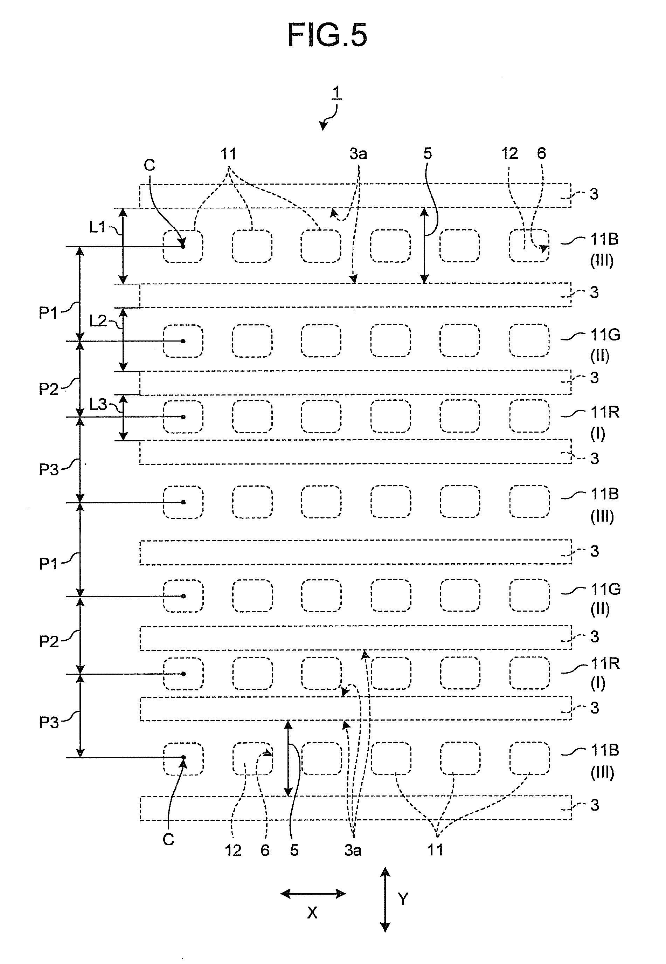

All of the intervals P between the centers C of a plurality of organic EL elements 11 adjacent to each other in the column direction Y may be the same as each other, or the interval P may be set to a value periodically variable with one period of a value "m". One example of the latter is illustrated in FIG. 5. As illustrated in FIG. 5, the intervals L1, L2, and L3 between the partitions 3 adjacent to each other are set, for example, according to a type of the organic EL element provided between the partitions 3 adjacent to each other, so that it is periodically varied (in FIG. 5, one set of L1, L2, and L3 becomes one period). However, corresponding to this variation, the intervals P1, P2, and P3 between the centers C of a plurality of organic EL elements 11 in the column direction Y may be periodically varied. In this case, the widths of all partitions 3 in the column direction Y may be made the same. On the other hand, as illustrated in FIG. 1, when the organic EL elements 11 are provided such that all of the intervals P between the centers C of a plurality of organic EL elements 11 adjacent to each other in the column direction Y become the same, by adjusting the location in the column direction Y at which the partition 3 is arranged and the width of the partition 3 in the column direction Y, the area between the partitions 3 adjacent to each other in the column direction in a plan view can be varied according to a type of the organic EL element 11. In this case, by the below-described nozzle printing method, irrespective of the type of the organic EL element 11, ink can be applied at the same interval, so that the composition and the control of an ink applying device become easier.

In the present embodiment, between the supporting substrate 2 and the partition 3, there is provided the lattice-shaped insulating film 4 for electrically insulating each organic EL element 11. The insulating film 4 is constituted by integrally forming a plurality of belt-shaped parts extending in the line direction X and a plurality of belt-shaped parts extending in the column direction Y. An opening 6 of the lattice-shaped insulating film 4 is formed at a position at which the insulating film 4 overlaps with the organic EL element 11 in a plan view. The opening 6 of the insulating film 4 is formed in a shape such as an oval shape, a substantially circular shape, a substantially elliptical shape, and a substantially rectangular shape in a plan view. The partition 3 is formed on a part constituting a part of the insulating film 4 and extending in the line direction X. The insulating film 4 is provided if necessary. For example, the insulating film 4 is provided for securing electrical insulation between the organic EL elements 11 adjacent to each other in the line direction X or in the column direction Y.

A current flowing in the thickness direction Z of the supporting substrate 2 flows only in a region in which the opening 6 of the insulating film 4 is formed, so that only a region overlapping with the opening 6 in a plan view functions as the organic EL element 11 and emits light.

The widths of the organic EL elements 11 in the line direction X and the column direction Y in a plan view are defined by a region for emitting light, so that they are defined by the widths of the opening 6 of the insulating film 4 in the line direction X and the column direction Y respectively. When the insulating film 4 is not provided, the widths of the organic EL element 11 in the column direction Y and the line direction X in a plan view are defined by the widths of the below-described one electrode 12 in the column direction Y and the line direction X respectively.

The organic EL element 11 is classified into m types (the symbol "m" represents a natural number of 2 or more) of elements emitting lights of different colors. Each of the plurality of types of organic EL elements 11 provided on the supporting substrate 2 has a common layer 14 provided commonly to all types of the organic EL elements 11 and a pair of electrodes (12, 13) configured to put the common layer 14 therebetween. Between the pair of electrodes of the organic EL element 11, a light-emitting layer 15 is provided.

The film thickness of the common layer 14 is varied according to a type of the organic EL element 11, because, in order to control the distance between a pair of electrodes for producing optical resonance for example, the film thickness of the common layer 14 may be controlled according to a type of the organic EL element 11 or according to a type of the light-emitting layer 15, an optimal film thickness of the common layer 14 may exist, so that with conforming with the optimal value, the film thickness of the common layer 14 may be controlled according to a type of the organic EL element 11.

Thus, by controlling the film thickness of the common layer 14 according to a type of the organic EL element 11, a common layer 14 having an optimal film thickness according to the material of the light-emitting layer 15 can be formed or the distance between the pair of electrodes can be controlled so as to make an optical resonance.

The common layer 14 comprises, for example, an organic layer different from the light-emitting layer 15, a layer containing an inorganic substance and an organic substance, and an inorganic layer. As the common layer 14, specifically, there are provided a so-called hole injection layer, hole transport layer, electron block layer, hole block layer, electron transport layer, and electron injection layer. The organic EL element 11 illustrated in FIG. 2 comprises, as one example, a pair of electrodes, one common layer 14, and one light-emitting layer 15. As described below, for example, the organic EL element 11 is constituted by stacking an anode corresponding to one electrode 12 among the pair of electrodes, a hole injection layer corresponding to the common layer 14, the light-emitting layer 15, and a cathode corresponding to the other electrode 13 among the pair of electrodes in this order from the side of the supporting substrate 2.

Hereinafter, although an organic EL element 11 having a composition in which one common layer 14 is arranged at a position nearer to one electrode 12 than to the light-emitting layer 15 is described, the present invention is not limited to this composition and a plurality of common layers 14 may be arranged, the common layer 14 may be provided at a position nearer to the other electrode 13 than to the light-emitting layer 15, or common layers 14 may be arranged both at a position between the light-emitting layer 15 and one electrode 12 and at a position between the light-emitting layer 15 and the other electrode 13.

Any one electrode among the pair of electrodes is constituted by a member exhibiting optical transparency, for transmitting light emitted from the light-emitting layer 15 and emitting the light to the outside. An electrode exhibiting optical transparency transmits not all the light entering the electrode and reflects a part thereof.

Therefore, even in a so-called bottom emission-type organic EL element 11 in which one electrode 12 is constituted by an electrode exhibiting optical transparency, light reflected once on one electrode 12 and reflected again on the other electrode 13 and light emitted from the light-emitting layer 15 resonate with each other, so that by controlling the film thickness of the common layer 14 illustrated in FIG. 2, optical resonance can be made.

Needless to say, in the case of a so-called top emission-type organic EL element 11 in which the other electrode 13 is constituted by an electrode exhibiting optical transparency, by controlling the film thickness of the common layer 14 illustrated in FIG. 2, the optical path length of light reflected on one electrode 12 can be controlled, so that optical resonance can be made.

The pair of electrodes (12, 13) is constituted by an anode and a cathode. As one electrode among the anode and the cathode, one electrode 12 among the pair of electrodes is placed at a position nearer to the supporting substrate 2 and as another electrode among the anode and the cathode, the other electrode 13 among the pair of electrodes is placed by separating from the supporting substrate 2 farther than one electrode 12.

The light-emitting device 1 of the present embodiment is an active matrix-type device, so that one electrode 12 is individually provided for each organic EL element 11. One electrode 12 is formed, for example, in a plate shape and in a substantially rectangular shape in a plan view. One electrode 12 is provided in a matrix shape corresponding to the position at which each organic EL element 11 is provided on the supporting substrate 2. Each electrode 12 is arranged at a prescribed interval in the line direction X and at a prescribed interval in the column direction Y. That is, one electrode 12 is provided between the partitions 3 adjacent to each other in the column direction Y in a plan view. Each electrode 12 is arranged in each space between the partitions 3 at a prescribed interval in the line direction X. In the present embodiment, one electrode 12 is formed in substantially the same shape as that of the above-described opening 6 of the insulating film 4 in a plan view and is formed wider than the opening 6.

The above-described lattice-shaped insulating film 4 is formed mainly in a region excluding one electrode 12 in a plan view and a part thereof is formed by covering a periphery of one electrode 12. In other words, in the insulating film 4, the opening 6 is formed on one electrode 12. With the opening 6, the surface of one electrode 12 is exposed from the insulating film 4. The partitions 3 are provided on a plurality of belt-shaped parts constituting a part of the insulating film 4 and extending in the line direction X.

The common layer 14 extends in the line direction X in a region interposed between the partitions 3 adjacent to each other. That is, the common layer 14 is formed in a belt shape in a plurality of concave portions 5 defined by the partitions 3 adjacent to each other in the column direction Y. Then, the film thickness of the common layer 14 of each organic EL element 11 is set according to the area between the partitions 3 adjacent to each other viewed from one side of the thickness direction.

As described below, the common layer 14 is formed by applying ink containing a material of the common layer 14 to the concave portion 5, forming a film, and solidifying the resultant film. Then, to each concave portion 5, the same amount of the ink is supplied. Therefore, the larger the area between the partitions 3 in a plan view is, the smaller the film thickness of the common layer 14 formed between the partitions 3 is. On the contrary, the larger the area between the partitions 3 is, the larger the film thickness of the common layer 14 formed between the partitions 3 is.
In the example illustrated in FIG. 2, the interval between the partitions 3 adjacent to each other satisfies a relationship of L1>L2>L3, so that each common layer 14 satisfies a relationship of "film thickness of a region corresponding to L1" < "film thickness of a region corresponding to L2" < "film thickness of a region corresponding to L3".

Like the common layer 14, the light-emitting layer 15 extends in the line direction X in a region interposed between the partitions 3 adjacent to each other. That is, the light-emitting layer 15 is formed in a belt shape in the concave portion 5 defined by the partitions 3 adjacent to each other in the column direction Y. In the present embodiment, the light-emitting layer 15 is provided by stacking the light-emitting layer 15 on the common layer 14.

In the case of a color display device, as described above, for example, it is necessary to provide three types of organic EL elements 11 emitting each type of red light, green light, and blue light on the supporting substrate 2. In the present embodiment, by varying the type of the light-emitting layer 15, three types of organic EL elements 11 emit each type of red light, green light, and blue light are produced.

Therefore, three types of lines such as (i) a line in which a light-emitting layer emitting red light is provided, (ii) a line in which a light-emitting layer emitting green light is provided, and (iii) a line in which a light-emitting layer emitting blue light is provided, are repeatedly (in FIG. 1, repeatedly from below to upper) arranged in this order. That is, two light-emitting layers emitting a red color light, two light-emitting layers emitting a green color light, and two light-emitting layers emitting a blue color light are arranged by spacing two lines therebetween in the column direction Y and are sequentially layered on the common layer as belt-shaped layers extending in the line direction X.

The other electrode 13 among the pair of electrodes is provided on the light-emitting layer 15. In the present embodiment, the other electrode 13 is formed continuously over a plurality of organic EL elements 11 and is provided as an electrode common to a plurality of organic EL elements 11. That is, the other electrode 13 is formed not only on the light-emitting layer 15, but also on the partition 3 and is formed all over so that an electrode on the light-emitting layer 15 and an electrode on the partition 3 line up.

### <Manufacturing method for light-emitting device>

Next, the manufacturing method for a display device is described.

First, a supporting substrate 2 is prepared. As the supporting substrate 2 for an active matrix-type display device, a substrate in which a driving circuit for individually driving a plurality of organic EL elements 11 is formed beforehand, can be used. For example, a thin film transistor (TFT) substrate can be used as the supporting substrate 2.

### (Step of forming one electrode among a pair of electrodes on supporting substrate)

Next, on the prepared supporting substrate 2, a plurality of electrodes 12 are formed in a matrix shape. One electrode 12 is formed, for example, by a method comprising the steps of: forming a conductive thin film all over on the supporting substrate 2; and patterning the conductive thin film in a matrix shape using a photolithography method (in the description below, "photolithography method" comprises a patterning step such as an etching step performed following a mask pattern forming step). The electrode 12 may be patterned, for example, by a method comprising: arranging a mask pattern in which an opening is formed in a portion corresponding to a pattern in which the electrode 12 is to be formed on the supporting substrate 2; and selectively depositing a conductive material in a prescribed portion on the supporting substrate 2 through the mask pattern. The material for the electrode 12 is described below. In the present step, a supporting substrate 2 in which one electrode 12 is formed beforehand may be prepared.

Next, in the present embodiment, the insulating film 4 is formed in a lattice shape on the supporting substrate 2. The insulating film 4 is constituted by an organic substance or an inorganic substance. The organic substance constituting the insulating film 4 may be resins such as an acrylic resin, a phenolic resin, or a polyimide resin. The inorganic substance constituting the insulating film 4 may be SiOₓ or SiNₓ.

When an insulating film 4 containing an organic substance is formed, first, for example, a positive or negative photosensitive resin is applied all over to the supporting substrate 2 and a prescribed portion is exposed and developed. Furthermore, by curing the resultant coating, there is formed an insulating film 4 in which the opening 6 is formed in a prescribed portion. As the photosensitive resin, a photoresist can be used.

When an insulating film 4 containing an inorganic substance is formed, a thin film containing an inorganic substance is formed all over on the supporting substrate 2 by a plasma CVD method, a sputtering method, or the like. Next, by forming the opening 6 in a prescribed portion, the insulating film 4 is formed. The opening 6 is formed, for example, by a photolithography method. By forming the opening 6, the surface of the electrode 12 is exposed.

Next, in the present embodiment, a plurality of stripe-shaped partitions 3 are formed on the insulating film 4. The partition 3 can be formed in a stripe pattern using, for example, a material exemplified as the material for the insulating film 4 in the same manner as that for forming the insulating film 4. In the present embodiment, each partition 3 is formed, as described above, such that the intervals L1, L2, and L3 between the partitions 3 adjacent to each other become the intervals according to the type of the organic EL element 11 provided between the partitions 3.

The shape and the arrangement of the partition 3 and the insulating film 4 are appropriately set according to the specifications of the display device such as the number of pixels and the resolution and the easiness of the manufacturing. For example, the width T1 of the partition 3 in the column direction Y is around 5 µm to 50 µm; the height T2 of the partition 3 is around 0.5 µm to 5 µm; and the interval T3 between the partitions 3 adjacent to each other in the column direction Y, that is, the width T3 of the concave portion 5 in the column direction Y is around 10 µm to 200 µm. The widths of the opening 6 formed in the insulating film 4 in the line direction X and the column direction Y are individually around 10 µm to 400 µm.

### (Step of forming common layer)

Next, in the present embodiment, the common layer 14 is formed on the electrode 12. In the present step, while supplying a liquid column-shaped ink containing a material of the common layer 14 to a prescribed line defined by the partition 3, by moving the position to which the ink is supplied in the line direction, the common layer 14 is applied and film-formed in the prescribed line. That is, by a so-called nozzle printing method, the common layer is formed.

In the nozzle printing method, the ink is supplied to each line (concave portion) with a so-called single stroke. For example, while discharging a liquid column-shaped ink through a nozzle arranged over the supporting substrate 2, by reciprocating the nozzle in the line direction X and by moving the supporting substrate 2 in the column direction by one line (in FIG. 1, the distance represented by P) during the turn of the reciprocation of the nozzle, the ink is sequentially supplied to each line.

Specifically, while discharging the liquid column-shaped ink through the nozzle, by repeating the actions (1) to (4) below in this order, the ink is sequentially supplied to all lines: (1) moving the nozzle from one end to the other end in the line direction X on a prescribed line (out-bound); (2) moving the supporting substrate 2 in the column direction Y by one line (turn); (3) moving the nozzle from the other end to one end in the line direction X on a prescribed line (in-bound); and (4) moving the supporting substrate 2 in the column direction Y by one line (turn). In the example illustrated in FIG. 5, during the turn of the reciprocation of the nozzle, the supporting substrate 2 may be moved in the column direction repeatedly in the order of P1, P2, and P3.

Thus, by supplying the ink to each line (concave portion) with a single stroke, the same amount of the ink is supplied to each line.
As illustrated in FIG. 1, the each area between the partitions 3 adjacent to each other in the column direction is varied according to a type of the organic EL element 11 provided between the partitions 3, so that when the same amount of the ink is supplied to each line, the film thickness of the common layer 14 after the solidification of the ink becomes a value according to the area between the partitions 3. That is, the larger the area between the partitions 3 is, the smaller the film thickness of the common layer 14 formed between the partitions 3 is. On the contrary, the larger the area between the partitions 3 is, the larger the film thickness of the common layer 14 formed between the partitions 3 is. Therefore, without varying the applying amount of the ink according to a type of the organic EL element 11, the film thickness of the common layer 14 can be varied according to a type of the organic EL element 22.

The common layer 14 can be formed by solidifying the ink supplied between the partitions 3. The solidification of the ink can be performed, for example, by removing the solvent. The removal of the solvent can be performed by natural drying, heating drying, vacuum drying, or the like. When an ink containing a material to be polymerized by applying energy such as light and heat is used, the ink may be solidified by applying energy such as light and heat after the ink is supplied between the partitions 3.

Although in the present embodiment, the step of applying the ink using one nozzle is described, in another embodiment, not limited to one nozzle, but the ink may be applied using a plurality of nozzles. Although in the present embodiment, one common layer 14 is formed by a nozzle printing method, when a plurality of common layers 14 are provided in one organic EL element 11, at least one common layer 14 among the common layers 14 may be formed by the above-described nozzle printing method, or a plurality of common layers 14 may be formed by the above-described nozzle printing method.

### (Step of forming light-emitting layer)

As described above, when the light-emitting device 1 used for a color display device is manufactured, for manufacturing three types of organic EL elements 11, for example, materials for the light-emitting layer 15 are necessary to be painted in different colors according to a type of the organic EL element 11. For forming three types of light-emitting layers 15 for each line, it is necessary to apply a red ink containing a material emitting red light, a green ink containing a material emitting green light, and a blue ink containing a material emitting blue light by individually spacing two lines in the column direction Y. For example, by applying a red ink, a green ink, and a blue ink sequentially to a prescribed line, each light-emitting layer 15 can be coated and film-formed. The method for applying sequentially a red ink, a green ink, and a blue ink to a prescribed line may be applying methods such as a printing method, an inkjet method, or a nozzle printing method. For example, by a method similar to the above-described method for forming the common layer 14 in which during the turn of the reciprocation of the nozzle, the supporting substrate 2 is moved by three lines (in FIG. 1, a distance indicated by 3 x P) in the column direction to supply the ink sequentially to each line and form the common layer 14, the light-emitting layer 15 may be formed.

After the light-emitting layer 15 is formed, if necessary, a prescribed organic layer and the like are formed by a prescribed method.
These layers may be formed using a prescribed applying method such as a printing method, an inkjet method, and a nozzle printing method and further, a prescribed dry method.

(Step of forming another electrode among a pair of electrodes)
Next, another electrode 13 is formed. As described above, in the present embodiment, another electrode 13 is formed all over on the supporting substrate 2. A plurality of organic EL elements 11 can be thus formed on the substrate.

As described above, even when, by setting the each area between the partitions 3 adjacent to each other in the column direction as viewed from one side of the thickness direction of the supporting substrate 2 according to a type of the organic EL element 11 provided between the partitions 3, the same amount of the ink is supplied to each line using a nozzle printing method, the film thickness of the common layer 14 can be varied according to a type of the organic EL element 11. While, in the conventional art, by varying the applying amount of the ink according to a type of the organic EL element 11, the film thickness of the common layer 14 is controlled, in the present invention, without varying the applying amount of the ink according to a type of the organic EL element 11, the film thickness of the common layer 14 can be varied according to a type of the organic EL element 11, so that the number of steps can be reduced in comparison with a conventional art.

A side face 3a of a partition 3 opposite to another partition 3 adjacent to the partition 3 in the column direction extends flat in the line direction and when, by controlling the interval between the partitions 3, the each area between the partitions 3 adjacent to each other in the column direction is set according to a type of the organic EL element 11 provided between the partitions 3 (see FIG. 1), the side face 3a of the partition 3 is formed not uneven but flat. By forming a thin film between such partitions 3 of which side face 3a is flat using an applying method, a planar film (such as common layer 14 and light-emitting layer 15) can be obtained. When the common layer 14 or the light-emitting layer 15 is formed by an applying method, the ink is gradually dried and solidified and a film is formed along the side face 3a of the partition 3, so that, when the side face 3a of the partition 3 is flat, a planar film can be obtained.

When the organic EL elements 11 are arranged at a prescribed interval so that the distances between the centers C of the organic EL elements 11 become the same in the column direction, by the nozzle printing method, the ink can be applied at the same interval (in FIG. 1, the interval is represented by P) irrespective of the type of the organic EL element 11, so that the composition and the control of an ink applying device become easier.

The each area between the partitions 3 adjacent to each other in the column direction as viewed from one side of the thickness direction of the supporting substrate 2 is preferably set so that the film thickness of the common layer 14 of the organic EL element 11 provided between the partitions 3 becomes a film thickness by which optical resonance is made in the organic EL element 11. Optical resonance can be made by controlling the distance between a pair of electrodes. The distance between a pair of electrodes can be controlled by controlling the film thickness of the common layer 14. That is, by controlling the film thickness of the common layer 14, optical resonance can be made.

In the present specification, "optical resonance" means an action of strengthening light intensity at a specific wavelength by such an action that light reflected on an electrode and light emitted from the light-emitting layer 15 strengthen each other or such an action that the reflected lights strengthen each other. By controlling the film thickness of the common layer 14 such that optical resonance is made, the spectrum can be made a narrow band and the light-emitting efficiency can be enhanced. For example, for making optical resonance, the film thickness of the common layer 14 may be controlled so that the phase difference between light returning to the light-emitting layer 15 by being reflected on the electrode and light emitted from the light-emitting layer 15 becomes an integral multiple of 2π (radian).

The each area between the partitions 3 adjacent to each other in the column direction as viewed from one side of the thickness direction of the supporting substrate 2 is preferably set larger as the light-emitting wavelength of the organic EL element 11 provided between the partitions 3 is smaller. Hereinafter, the description will be made based on the above-described embodiment. As the light-emitting wavelength, a light-emitting wavelength for blue is the shortest, a light-emitting wavelength for green is medium, and a light-emitting wavelength for red is the longest. Therefore, the area SB: the area between the partitions 3 in which an organic EL element 11B emitting blue light is provided, the area SG: the area between the partitions 3 in which an organic EL element 11G emitting green light is provided, and the area SR: the area between the partitions 3 in which an organic EL element 11R emitting red light is provided, satisfy the relationship: "area SB" > "area SG" > "area SR".

The film thickness of the common layer 14 is in inverse proportion to the area between the partitions 3 such that the larger the area is, the smaller the film thickness is and the smaller the area is, the larger the film thickness is. Therefore, the film thickness LB of the common layer 14 of the organic EL element 11B, the film thickness LG of the common layer 14 of the organic EL element 11G, and the film thickness LR of the common layer 14 of the organic EL element 11R, satisfy the relationship: "film thickness LB" < "film thickness LG" < "film thickness LR".

Then, although the distance between a pair of electrodes when light resonates exists discretely, the smaller the light-emitting wavelength is, the smaller the smallest distance among them is. Therefore, in order to make optical resonance, it is preferred to satisfy the relationship: "film thickness LB" < "film thickness LG" < "film thickness LR". By setting the area between the partitions 3 larger as the light-emitting wavelength of the organic EL element 11 provided between the partitions 3 is smaller, like the relationship between the distance between a pair of electrodes and the light-emitting wavelength when light resonates, the smaller the light-emitting wavelength of the organic EL element 11 is, the smaller the distance between a pair of electrodes can be made.

An organic EL element 11 having the shortest element life among m types (the symbol "m" represents a natural number of 2 or more) of organic EL elements 11 is preferably an organic EL element 11 having the largest width in the line direction. The element life means a time period required until the brightness of the organic EL element 11 lowers to 80% of the initial brightness thereof when the organic EL element 11 is started to be constant current-driven.

As another embodiment, a light-emitting device 1 in which an organic EL element 11 having the shortest element life among m types (the symbol "m" represents a natural number of 2 or more) of organic EL elements 11 is an organic EL element 11 having the largest width in the line direction, is schematically illustrated in FIG. 3.

As described above, the widths of the organic EL element 11 in the column direction Y and in the line direction X in a plan view are defined by a region in which the organic EL element 11 emits light, so that the widths of the organic EL element 11 in the column direction Y and in the line direction X in a plan view are defined by the widths of the opening 6 of the insulating film 4 in the column direction Y and in the line direction X respectively. Therefore, an organic EL element 11 having the shortest element life among m types (the symbol "m" represents a natural number of 2 or more) of organic EL elements 11 may be set such that the width of the opening 6 of the insulating film 4 in the column direction Y becomes the largest.

For example, when the element life of an organic EL element 11B emitting blue light is the shortest, the element life of an organic EL element 11G emitting green light is the next shortest, and the element life of an organic EL element 11R emitting red light is the longest, the width of an organic EL element 11B emitting blue light in the column direction Y may be made the longest, the width of an organic EL element 11G emitting green light in the column direction Y may be made the next longest, and the width of an organic EL element 11R emitting red light in the column direction Y may be made the shortest.

Thus, by defining the width of the organic EL element 11 to enlarge the light-emitting area of an organic EL element 11, the shorter the element life of the organic EL element 11 is, the larger the light-emitting area is, to thereby reduce the light-emitting amount per unit area, the load during driving can be reduced. The element life of an organic EL element 11 having a short element life can be thus lengthened corresponding to the element life of other organic EL elements when the light-emitting areas are the same.

Particularly, the shorter the light-emitting wavelength of the organic EL element is, the shorter the element life of the organic EL element tends to be, and therefore, the shorter the light-emitting wavelength of the organic EL element 11 provided between the partitions 3 is, the larger the each area between the partitions 3 adjacent to each other in the column direction can be set, and an organic EL element having the shortest element life among m types (the symbol "m" represents a natural number of 2 or more) of organic EL elements 11 can be used as an organic EL element having the largest width in the line direction. Accordingly, optical resonance can be made and when the light-emitting area is the same, the element life of an organic EL element having a short element life can be lengthened corresponding to the element life of other organic EL elements.

Furthermore, in another embodiment, it is preferred that each organic EL element 11 have a plurality of common layers 14 and the film thickness of all the common layers 14 of each organic EL element 11 be set according to the area between the partitions 3 viewed from one side of the thickness direction. As the conventional art, there is known a method for controlling the distance between a pair of electrodes by controlling the film thickness of a prescribed one layer provided between the electrodes.

In the present embodiment, by setting the each area between the partitions 3 adjacent to each other in the column direction according to a type of the organic EL element 11 provided between the partitions 3, the film thickness of all the common layers 14 of each organic EL element 11 can be controlled according to a type of the organic EL element 11.
Thus, by controlling gradually all of the common layers 14, in comparison with the conventional art for controlling only the film thickness of a prescribed one layer, a controlled amount of the film thickness of each common layer 14 can be reduced. The influence on element characteristics due to the control of the film thickness of the common layer 14 can be thus suppressed.

In another embodiment, the width (size) of the interval between the partitions 3 may be varied along the line direction according to the type of the organic EL element provided between the partitions 3. As one example of other embodiments, there is illustrated in FIG. 4, a plane view schematically illustrating a light-emitting device 1 in which the width of the interval between the partitions is varied along the line direction according to the type of the organic EL element provided between the partitions.

As illustrated in FIG. 4, in the present embodiment, on the side face 3a of the partition 3, along the line direction X, there is formed a convexo-concave (convex portion) for varying the area of a face (supporting substrate) exposed from the partition 3. For example, by setting the size of each convex portion in a plan view according to a type of the organic EL element 11, the each area between the partitions 3 adjacent to each other in the column direction can be set according to a type of the organic EL element 11 provided between the partitions 3. Specifically, when the area between the partitions 3 in a plan view is decreased, the area of each convex portion in a plan view may be increased and when the area between the partitions 3 in a plan view is increased, the area of each convex portion in a plan view may be decreased.

In FIG. 4, although a convexo-concave is formed on the both sides of the side face 3a of a pair of partitions 3 facing a prescribed line, the convexo-concave may be provided on only one side of the side face 3a of a pair of partitions 3. In addition, on all the side faces 3a of the partitions 3, the convexo-concave may be formed. Furthermore, as illustrated in FIG. 4, there may be provided a partition 3 in which both side faces 3a of a pair of partitions 3 facing a prescribed line are planar.

A convex portion projecting toward a partition 3 adjacent in one direction of the column direction Y in a plan view is preferably provided, for example, between an organic EL element 11 and an organic EL element 11 that are adjacent to each other in the line direction X. Although by providing a convex portion in the partition 3, a region in which the organic EL element 11 is provided may be limited, by providing a convex portion so that the convex portion is placed between the organic EL elements 11 adjacent to each other in the line direction X, it can be suppressed as much as possible so that the area in which the organic EL element 11 is provided is limited and as the result thereof, lowering of the opening ratio can be suppressed.

In the above embodiment, although the symbol "m" representing a natural number of 2 or more is described as representing a value "3", m may be 2, or 4 or more. For example, in the case of m=4, there may be provided an organic EL element emitting lights of colors comprising red, green, and blue, which are the three primary colors of light, and a color that is one color among the three colors of red, green, and blue, but has a spectrum slightly different from that of any one of the three colors.

Specifically, there may be provided, in addition to an organic EL element emitting red light and an organic EL element emitting green light, an organic EL element emitting dark blue light and an organic EL element emitting light blue light. That is, there may be provided two types of organic EL elements emitting dark blue light and light blue light that are the same blue color, but have spectra different from each other.

In this case, although there are provided two types of organic EL elements emitting lights of two different blue colors, as the composition thereof, there can be considered the following elements:
(1) two types of organic EL elements having light-emitting layers of different types formed using blue color materials of different types; and
(2) two types of organic EL elements having light-emitting layers of the same type formed from the same blue color material in which the film thicknesses of the common layer are different from each other.

The organic EL elements of (2) have film thicknesses of the common layer different from each other, so that resonance frequencies thereof are different from each other and as the result, spectra of the emitted lights thereof are different from each other.

For example, an organic EL element emitting dark blue light and an organic EL element emitting light blue light, where even a dark blue color and a light blue color are the same blue color, may be different from each other in element characteristics such as light-emitting efficiency and element life. In this case, in usual light emission, an organic EL element emitting one blue color light having high element characteristics among an organic EL element emitting dark blue light and an organic EL element emitting light blue light may be caused to emit light, and particularly, only when another blue color light becomes necessary, an organic EL element having low element characteristics and emitting another blue color light may be caused to emit light.

### <Composition of organic EL element>

Hereinafter, the composition of the organic EL element 11 is described. As described above, the organic EL element 11 has various layer compositions. Hereinafter, one example of the layer structure, the composition of each layer, and the forming method of each layer of the organic EL element 11 is described.

In the organic EL element 11, there are provided a pair of electrodes and the light-emitting layer 15 placed between the pair of electrodes. Between an anode and a cathode, there may be provided not only the light-emitting layer, but also an organic layer different from the light-emitting layer and further, an inorganic layer different from the light-emitting layer may be provided. As the layer different from the light-emitting layer, in the present embodiment, the common layer 14 common to m types of organic EL elements 11 is provided between the pair of electrodes.

Although the organic substance constituting the organic layer may be a low molecular compound, a macromolecular compound, or a mixture of a low molecular compound and a macromolecular compound, the organic substance is preferably a macromolecular compound, and a macromolecular compound having a number average molecular in terms of polystyrene of 10³ to 10⁸.

When the organic layer is formed by an applying method, generally, a macromolecular compound has advantageous solubility in a solvent in comparison with a low molecular compound, so that a macromolecular compound having advantageous solubility in a solvent is preferred.

The layer provided between the cathode and the light-emitting layer may be an electron injection layer, an electron transport layer, or a hole block layer. When, between the cathode and the light-emitting layer, both of the electron injection layer and the electron transport layer are provided, a layer nearer to the cathode is called as "electron injection layer" and a layer nearer to the light-emitting layer is called as "electron transport layer".

The layer provided between the anode and the light-emitting layer may be a hole injection layer, a hole transport layer, or an electron block layer. When both of the hole injection layer and the hole transport layer are provided, a layer nearer to the anode is called as "hole injection layer" and a layer nearer to the light-emitting layer is called as "hole transport layer".

These layers provided between the cathode and the light-emitting layer and these layers provided between the anode and the light-emitting layer can be provided as a common layer commonly to all types of organic EL elements. Among these common layers, a common layer capable of being formed by an applying method is preferably formed by the above-described method for applying a liquid column-shaped ink of the present invention.

Examples of the element composition of the organic EL element 11 are shown as follows:
a) anode / light-emitting layer / cathode;
b) anode / hole injection layer / light-emitting layer /cathode;
c) anode / hole injection layer / light-emitting layer /electron injection layer / cathode;
d) anode / hole injection layer / light-emitting layer /electron transport layer / cathode;
e) anode / hole injection layer / light-emitting layer /electron transport layer / electron injection layer /cathode;
f) anode / hole transport layer / light-emitting layer /cathode;
g) anode / hole transport layer / light-emitting layer /electron injection layer / cathode;
h) anode / hole transport layer / light-emitting layer /electron transport layer / cathode;
i) anode / hole transport layer / light-emitting layer /electron transport layer / electron injection layer /cathode;
j) anode / hole injection layer / hole transport layer /light-emitting layer / cathode;
k) anode / hole injection layer / hole transport layer /light-emitting layer / electron injection layer / cathode;
l) anode / hole injection layer / hole transport layer /light-emitting layer / electron transport layer / cathode;
m) anode / hole injection layer / hole transport layer /light-emitting layer / electron transport layer / electron injection layer / cathode;
n) anode / light-emitting layer / electron injection layer / cathode;
o) anode / light-emitting layer / electron transport layer / cathode; and
p) anode / light-emitting layer / electron transport layer / electron injection layer / cathode.
The symbol "/" indicates that the layers interposing the symbol "/" are layered adjacent to each other. It is also the same in the description below.
Furthermore, the light-emitting layer 11 may have two or more light-emitting layers, or may have two or more light-emitting layers and may constitute a so-called multiphoton-type organic EL element in which an electric charge generating layer for generating an electric charge is interposed between the light-emitting layers adjacent to each other.

The organic EL element 11 may be further covered by a sealing member such as a sealing film and a sealing plate for sealing.

In the organic EL element 11 of the present embodiment, for enhancing adhesion with the electrode and improving electric charge injecting property from the electrode, an insulating layer having a film thickness of 2 nm or less may be further provided at a position adjacent to the electrode. For enhancing adhesion or preventing mixing at the interface, a thin buffer layer may be inserted between the above-described layers.

The order of stacking layers, the number of layers, and the thickness of each layer can be accordingly set with taking into consideration light-emitting efficiency and element life. In the organic EL element, among the anode and the cathode, the anode may be arranged at a position nearer to the supporting substrate and the cathode may be arranged at a position distant from the supporting substrate. On the contrary, the cathode may be arranged at a position nearer to the supporting substrate and the anode may be arranged at a position distant from the supporting substrate. Specifically, in the above compositions a) to p), each layer may be layered on the supporting substrate in the order from the leftmost layer or on the contrary, in the order from the rightmost layer.

Next, the material and the forming method of each layer constituting the organic EL element 11 are more specifically described.

### <Supporting substrate>

For the supporting substrate 2, for example, a glass, a plastic, a silicon substrate, and a layered body of these materials are used. As the supporting substrate 2 for forming an organic EL element 11 thereon, a substrate on which an electric circuit is formed beforehand may be used. When a bottom emission-type organic EL element is mounted on the substrate, as the supporting substrate 2, a member exhibiting optical transparency is used.

### <Anode>

In the case of an organic EL element having a composition in which light emitted from the light-emitting layer 15 is emitted through the anode, for the anode, an electrode exhibiting optical transparency is used. As the electrode exhibiting optical transparency, a thin film of a metal oxide, a metal sulfide, or a metal having high electric conductivity can be used and a material having high light transmittance is preferably used.

Specifically, there is used a thin film composed of indium oxide, zinc oxide, tin oxide, indium tin oxide (ITO), indium zinc oxide (IZO), gold, platinum, silver, copper, or the like and among them, a thin film composed of ITO, IZO, or tin oxide is preferably used. The forming method for the anode may be a vacuum evaporation method, a sputtering method, an ion plating method, or a plating method. As the anode, an organic transparent conductive film of a polyaniline or derivatives thereof, a polythiophene or derivatives thereof, or the like may be used.

For the anode, a material reflecting light may be used. As the material reflecting light, a metal, a metal oxide, and a metal sulfide having a work function of 3.0 eV or more are preferred.

The film thickness of the anode can be accordingly selected with taking into consideration light transparency and electric conductivity. The film thickness of the anode is, for example 10 nm to 10 µm, preferably 20 nm to 1 µm, and further preferably 50 nm to 500 nm.

### <Hole injection layer>

The hole injection material constituting the hole injection layer may be an oxide such as vanadium oxide, molybdenum oxide, ruthenium oxide, or aluminum oxide; a phenylamine compound; a star burst-type amine compound; a phthalocyanine compound; an amorphous carbon; a polyaniline; or a polythiophene derivative.

Examples of the film-forming method of the hole injection layer include film-forming from a solution containing a hole injection material. The solvent of the solution used for film-forming from the solution is not particularly limited so long as the solvent is a solvent capable of dissolving the hole injection material and examples thereof include: a chlorinated solvent such as chloroform, methylene chloride, and dichloroethane; an ether solvent such as tetrahydrofuran; an aromatic hydrocarbon solvent such as toluene and xylene; a ketone solvent such as acetone and methyl ethyl ketone; an ester solvent such as ethyl acetate, butyl acetate, and ethylcellosolve acetate; and water.

The film-forming method from the solution may be an applying method such as a spin coating method, a casting method, a micro gravure coating method, a gravure coating method, a bar coating method, a roll coating method, a wire bar coating method, a dip coating method, a spray coating method, a screen printing method, a flexo printing method, an off-set printing method, an inkjet printing method, or a nozzle printing method. The hole injection layer is preferably formed by the above-described nozzle printing method.

The film thickness of the hole injection layer is appropriately set with taking into consideration electric characteristics and easiness of film-forming. The film thickness of the hole injection layer is, for example 1 nm to 1 µm, preferably 2 nm to 500 nm, and further preferably 5 nm to 200 nm.

### <Hole transport layer>

The hole transport material constituting the hole transport layer may be polyvinyl carbazole or derivatives thereof, polysilane or derivatives thereof, a polysiloxane derivative having an aromatic amine in side chains or the main chain, a pyrazoline derivative, an arylamine derivative, a stilbene derivative, a triphenyldiamine derivative, polyaniline or derivatives thereof, polythiophene or derivatives thereof, a polyarylamine or derivatives thereof, polypyrrole or derivatives thereof, poly(p-phenylenevinylene) or derivatives thereof, or poly(2,5-thienylenevinylene) or derivatives thereof.

Among these hole transport materials, preferred are macromolecular hole transport materials such as polyvinyl carbazole or derivatives thereof, polysilane or derivatives thereof, a polysiloxane derivative having an aromatic amine compound group in side chains or the main chain, polyaniline or derivatives thereof, polythiophene or derivatives thereof, polyarylamine or derivatives thereof, poly(p-phenylenevinylene) or derivatives thereof, and poly(2,5-thienylenevinylene) or derivatives thereof, and further preferred are polyvinyl carbazole or derivatives thereof, polysilane or derivatives thereof, and a polysiloxane derivative having aromatic amine in side chains or the main chain. A low molecular hole transport material is preferably used by being dispersed in a macromolecular binder.

The film-forming method of the hole transport layer is not particularly limited. The film-forming method using a low molecular hole transport material may be film-forming from a mixture containing a macromolecular binder and a hole transport material, and the film-forming method using a macromolecular hole transport material may be film-forming from a solution containing a hole transport material.

The solvent of the solution used for film-forming from the solution is not particularly limited so long as the solvent is a solvent capable of dissolving the hole transport material and for example, there can be used a solvent exemplified as the solvent of the solution used for film-forming the hole injection layer from the solution.

The film-forming method from the solution may be the same applying method as the above-described film-forming method of the hole injection layer and the hole transport layer is preferably formed by the above-described nozzle printing method.

As the macromolecular binder to be mixed, a binder that does not extremely inhibit the electric charge transport is preferred and a binder that absorbs weakly a visible light is preferably used. Examples of such a binder include polycarbonate, polyacrylate, polymethyl acrylate, polymethyl methacrylate, polystyrene, polyvinyl chloride, and polysiloxane.

The film thickness of the hole transport layer is appropriately set with taking into consideration electric characteristics and easiness of film-forming. The film thickness of the hole transport layer is, for example, 1 nm to 1 µm, preferably 2 nm to 500 nm, and further preferably 5 nm to 200 nm.

### <Light-emitting layer>

Usually, the light-emitting layer 15 is formed mainly from an organic substance emitting fluorescence and/or phosphorescence, or this organic substance and a dopant assisting the organic substance. The dopant is blended, for example, for enhancing light-emitting efficiency or changing the light-emitting wavelength. The organic substance may be a low molecular compound or a macromolecular compound and the light-emitting layer 15 contains preferably a macromolecular compound having a number average molecular in terms of polystyrene of 10³ to 10⁸. Examples of the light-emitting material constituting the light-emitting layer 15 include a dye material, a metal complex material, a macromolecular material, and a dopant material below.

### (Dye material)

Examples of the dye material include a cyclopentamine derivative, a tetraphenylbutadiene derivative compound, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a perinone derivative, a perylene derivative, an oligothiophene derivative, an oxadiazole dimer, a pyrazoline dimer, a quinacridone derivative, and a coumarin derivative.

### (Metal complex material)

Examples of the metal complex material include a metal complex having as a central metal, a rare metal such as Tb, Eu, and Dy, or Al, Zn, Be, Ir, or Pt and having as a ligand, an oxadiazole, thiadiazole, phenylpyridine, phenylbenzimidazole, or quinoline structure, and specific examples thereof include a metal complex having light-emitting from a triplet excited state such as an indium complex and a platinum complex, an aluminum-quinolinole complex, a benzoquinolinol-beryllium complex, a benzoxazolyl-zinc complex, a benzothiazole-zinc complex, an azomethyl-zinc complex, a porphyrin-zinc complex, and a phenanthroline-europium complex.

### (Macromolecular material)

Examples of the macromolecular material include a poly-p-phenylenevinylene derivative, a polythiophene derivative, a poly-p-phenylene derivative, a polysilane derivative, a polyacetylene derivative, a polyfluorene derivative, a polyvinylcarbazole derivative, and a material prepared by polymerizing the above dye material, or a metal complex light-emitting material.

Among the above light-emitting materials, the material emitting blue light may be a distyrylarylene derivative, an oxadiazole derivative, a polymer of these derivatives, a polyvinylcarbazole derivative, a poly-p-phenylene derivative, and a polyfluorene derivative. Among them, preferred are macromolecular materials such as a polyvinylcarbazole derivative, a poly-p-phenylene derivative, or a polyfluorene derivative.

Examples of the material emitting green light include a quinacridone derivative, a coumarin derivative, a polymer of these derivatives, a poly-p-phenylenevinylene derivative, and a polyfluorene derivative. Among them, preferred are macromolecular materials such as a poly-p-phenylenevinylene derivative and a polyfluorene derivative.

Examples of the material emitting red light include a coumarin derivative, a thiophene ring compound, a polymer of these compounds, a poly-p-phenylenevinylene derivative, a polythiophene derivative, and a polyfluorene derivative. Among them, preferred are macromolecular materials such as a poly-p-phenylenevinylene derivative, a polythiophene derivative, and a polyfluorene derivative.

### (Dopant material)

Examples of the dopant material include a perylene derivative, a coumarin derivative, a rubrene derivative, a quinacridone derivative, a squarylium derivative, a porphyrin derivative, a styryl dye, a tetracene derivative, a pyrazolone derivative, decacyclene, and phenoxazone. The thickness of such a light-emitting layer is usually 2 nm to 200 nm.

Examples of the film-forming method of the light-emitting material include a printing method, an inkjet printing method, and a nozzle printing method. For example, as described above, by a nozzle printing method, it is possible to paint in different colors according to each color among m types of colors.

### <Electron transport layer>

As the electron transport material constituting the electron transport layer, a publicly-known electron transport material can be used. Examples of the electron transport material include an oxadiazole derivative, anthraquinodimethane or derivatives thereof, benzoquinone or derivatives thereof, naphthoquinone or derivatives thereof, anthraquinone or derivatives thereof, tetracyanoanthraquinodimethane or derivatives thereof, a fluorenone derivative, diphenyldicyanoethylene or derivatives thereof, a diphenoquinone derivative, a metal complex of 8-hydroxyquinoline or derivatives thereof, polyquinoline or derivatives thereof, polyquinoxaline or derivatives thereof, and polyfluorene or derivatives thereof.

Among them, as the electron transport material, preferred are an oxadiazole derivative, benzoquinone or derivatives thereof, anthraquinone or derivatives thereof, a metal complex of 8-hydroxyquinoline or derivatives thereof, polyquinoline or derivatives thereof, polyquinoxaline or derivatives thereof, and polyfluorene or derivatives thereof, and further preferred are 2-(4-biphenylyl)-5-(4-tert-butylphenyl)-1,3,4-oxadiazole, benzoquinone, anthraquinone, tris(8-quinolinol) aluminum, and polyquinoline.

The film-forming method of the electron transport layer is not particularly limited. Examples of the film-forming method using a low molecular electron transport material include a vacuum evaporation method from powder and film-forming from a solution or a molten state, and the film-forming method using a macromolecular electron transport material may be film-forming from a solution or a molten state. In the case of film-forming from a solution or a molten state, a macromolecular binder may be used in combination. The film-forming method from a solution may be the same applying method as the above-described film-forming method of the hole injection layer.

The film thickness of the electron transport layer is appropriately set with taking into consideration electric characteristics and easiness of film-forming. The film thickness of the electron transport layer is, for example 1 nm to 1 µm, preferably 2 nm to 500 nm, and further preferably 5 nm to 200 nm.

### <Electron injection layer>

As the material constituting the electron injection layer, an optimal material is appropriately selected according to the type of the light-emitting layer 15. Examples of the material constituting the electron injection layer include an alkali metal, an alkaline earth metal, an alloy containing one or more type(s) of an alkali metal and an alkaline earth metal, an oxide, a halide, or a carbonate of an alkali metal or an alkaline earth metal, and a mixture of these substances. Examples of the alkali metal and the oxide, the halide, and the carbonate of the alkali metal include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline earth metal and the oxide, the halide, and the carbonate of the alkaline earth metal include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may be constituted with a layered body prepared by stacking two or more layers and examples thereof include a layered body of a LiF film and a Ca film. The electron injection layer is formed by an evaporation method, a sputtering method, a printing method, or the like. The film thickness of the electron injection layer is preferably around 1 nm to 1 µm.

### <Cathode>

The material for the cathode is preferably a material having a small work function and a high electric conductivity and capable of easily injecting electrons into the light-emitting layer 15. An organic EL element retrieving light from the side of the anode reflects light emitted from the light-emitting layer on the cathode to the anode side, so that the material for the cathode is preferably a material having a high visible light reflectivity.

As the material for the cathode, there can be used, for example, an alkali metal, an alkaline earth metal, a transition metal, and a metal of Group 13 in the Periodic Table.
Examples of the material for the cathode include: a metal such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; an alloy of two or more types of these metals; an alloy of one or more type(s) of these metals with one or more type(s) of gold, silver, platinum, copper, manganese, titanium, cobalt, nickel, tungsten, and tin; and graphite or a graphite intercalation compound. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

As the cathode, a transparent conductive electrode containing a conductive metal oxide and a conductive organic substance can be used. Specifically, examples of the conductive metal oxide include indium oxide, zinc oxide, tin oxide, ITO, and IZO and examples of the conductive organic substance include polyaniline or derivatives thereof and polythiophene or derivatives thereof. The cathode may be constituted by a layered body prepared by stacking two or more layers. The electron injection layer may be used as the cathode.

The film thickness of the cathode is appropriately set with taking into consideration electric conductivity and durability. The film thickness of the cathode is, for example 10 nm to 10 µm, preferably 20 nm to 1 µm, further preferably 50 nm to 500 nm.

The forming method for the cathode may be a vacuum evaporation method, a sputtering method, or a laminate method for thermocompression-bonding a metal thin film.

### <Insulating layer>

Examples of the material for the insulating layer include a metal fluoride, a metal oxide, and an organic insulating material. The organic EL element in which an insulating layer having a film thickness of 2 nm or less is provided may be an organic EL element in which an insulating layer having a film thickness of 2 nm or less is provided at a position adjacent to the cathode or an organic EL element in which an insulating layer having a film thickness of 2 nm or less is provided at a position adjacent to the anode.

### EXPLANATIONS OF LETTERS OR NUMERAL

1 Light-emitting device
2 Supporting substrate
3 Partition
3a Side face
4 Insulating film
5 Concave portion
6 Opening
11 Organic EL element
12 One electrode
13 Another electrode
14 Common layer
15 Light-emitting layer

## Claims

1. A light-emitting device comprising:
a supporting substrate;
a plurality of partitions provided on the supporting substrate and extending at a prescribed interval in a prescribed column direction in a line direction different from the column direction on the supporting substrate; and
a plurality of organic electroluminescent elements provided in each space between the partitions adjacent to each other in the column direction at a prescribed interval in the line direction,
wherein the organic electroluminescent elements are classified into two or more types of organic electroluminescent elements emitting lights of colors different from each other, each of the organic electroluminescent elements having a common layer provided commonly to all types of the organic electroluminescent elements and a pair of electrodes configured to put the common layer therebetween,
each area between the partitions adjacent to each other in the column direction as viewed from one side of a thickness direction of the supporting substrate is set according to a type of the organic electroluminescent element provided between the partitions, and
a film thickness of the common layer of the organic electroluminescent elements is set according to the area between the partitions viewed from one side of the thickness direction.

2. The light-emitting device according to claim 1, wherein the two or more types of organic electroluminescent elements are provided so that:
in the line direction, the organic electroluminescent elements of an identical type are provided at a prescribed interval; and
in the column direction, the two or more types of organic electroluminescent elements are repeatedly provided so that a prescribed arrangement in which all types of the organic electroluminescent elements are arranged in order is continued repeatedly in the column direction.

3. The light-emitting device according to claim 1, wherein a side face of each partition opposite to another partition adjacent to the partition in the column direction extends flat in the line direction, and the interval between the partitions adjacent to each other in the column direction is set according to a type of the organic electroluminescent element provided between the partitions.

4. The light-emitting device according to claim 1, wherein the organic electroluminescent elements are arranged at a prescribed interval so that in the column direction, the intervals between centers of the organic electroluminescent elements are identical.

5. The light-emitting device according to claim 1, wherein each interval between the partitions adjacent to each other in the column direction is set such that a width of the interval is varied along the line direction according to the type of the organic electroluminescent element provided between the partitions.

6. The light-emitting device according to claim 1, wherein the area between the partitions adjacent to each other in the column direction as viewed from one side of the thickness direction of the supporting substrate is set such that the film thickness of the common layer of the organic electroluminescent element provided between the partitions becomes a film thickness by which optical resonance occurs in the organic electroluminescent element.

7. The light-emitting device according to claim 1, wherein the shorter a light-emitting wavelength of the organic electroluminescent element provided between the partitions is, the larger the area between the partitions adjacent to each other in the column direction as viewed from one side of the thickness direction of the supporting substrate is set.

8. The light-emitting device according to claim 1, wherein the organic electroluminescent elements are set such that a width in the line direction of an organic electroluminescent element having shortest element life among the two or more types of organic electroluminescent elements becomes largest.

9. The light-emitting device according to claim 1, wherein each of the organic electroluminescent elements comprises a plurality of common layers, and a film thickness of all the common layers of each of the organic electroluminescent elements is set according to the area between the partitions viewed from one side of the thickness direction.
